# EUROPEAN PATENT APPLICATION

(11) **EP 4 832 738 A2**
(43) Date of publication of application: **28.10.2026**
(21) Application number: 26203711.2
(22) Date of filing: 06.09.2022
(51) Int. Cl.: H10W 42/60, H10W 44/20

(54) **PACKAGE-LEVEL ESD PROTECTION**

(30) Priority: 01.11.2021 US 202163274032 P; 05.09.2022 US 202217902912
(62) Document number(s) of the earlier application(s) in accordance with Art. 76 EPC: 22194221.2 / 4 174 940
(71) Applicant: MEDIATEK INC., Hsin-Chu 300 (TW)
(72) Inventor: LIAO, Yu-Cheng, 30078 Hsinchu City (TW); HUANG, Bo-Shih, 30078 Hsinchu City (TW); JAO, Che-Yuan, 30078 Hsinchu City (TW); LIN, Yi-Chieh, 30078 Hsinchu City (TW)
(74) Representative: Haseltine Lake Kempner LLP

(57) **Abstract**

The present invention provides a package (100) including a first pad (N1), a die (110), and at least one package ESD component (120, 130, 140). The first pad (N1) is configured to receive a signal from a device external to the package (100). The die (110) comprises a second pad (N2) and an internal circuit (112), wherein the internal circuit (112) is configured to receive the signal from the first pad (N1) via the second pad (N2)

## Description

### Field of the Invention

The present invention relates to a package with ESD design.

### Background of the Invention

In order to protect circuits of a die from being damaged by electrostatic discharge (ESD), one or more ESD protection circuits are designed within the die to pass a human body model (HBM) and charged device model (CDM) of ESD specifications. However, the die-level ESD protection circuits generally have higher parasitic effects; and if the die-level ESD protection circuits are designed with smaller size to lower the parasitic effects, the die-level ESD protection circuits will not have good ESD robustness for high-speed radio-frequency (RF) designs.

### Summary of the Invention

It is therefore an objective of the present invention to provide a package-level ESD design, which has lower parasitic effects and better ESD robustness, to solve the above-mentioned problems.

According to one embodiment of the present invention, a package comprising a first pad, a die and at least one package ESD component is disclosed. The first pad is configured to receive a signal from a device external to the package or transmit a signal from an internal circuit to the device external to the package. The die comprises a second pad and the internal circuit, wherein the internal circuit is configured to receive the signal from the first pad via the second pad or transmit the signal from the internal circuit to the first pad via the second pad. The at least one ESD component is positioned outside the die.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a package according to one embodiment of the present invention
FIG. 2 is a diagram illustrating the package ESD components according to a first embodiment of the present invention.
FIG. 3 is a diagram illustrating the package ESD components according to a second embodiment of the present invention.
FIG. 4 is a diagram illustrating the package ESD components according to a third embodiment of the present invention.
FIG. 5 is a diagram illustrating the package ESD components according to a fourth embodiment of the present invention.
FIG. 6 is a diagram illustrating the package ESD components according to a fifth embodiment of the present invention.
FIG. 7 is a diagram illustrating the package ESD components according to a sixth embodiment of the present invention.
FIG. 8 is a diagram illustrating the package ESD components according to a seventh embodiment of the present invention.
FIG. 9 is a diagram showing some embodiments of the package ESD blocking component.
FIG. 10 is a diagram showing some embodiments of the package ESD blocking component.
FIG. 11 is a diagram of using the inductor to implement the package ESD conducting component when the die comprises a circuit for processing signals according to one embodiment of the present invention.
FIG. 12 is a diagram illustrating the designs of the inductor shown in FIG. 11 according to one embodiment of the present invention.
FIG. 13 is a diagram illustrating a vertical cross-sectional view of the circuit connected to the BGA ball.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

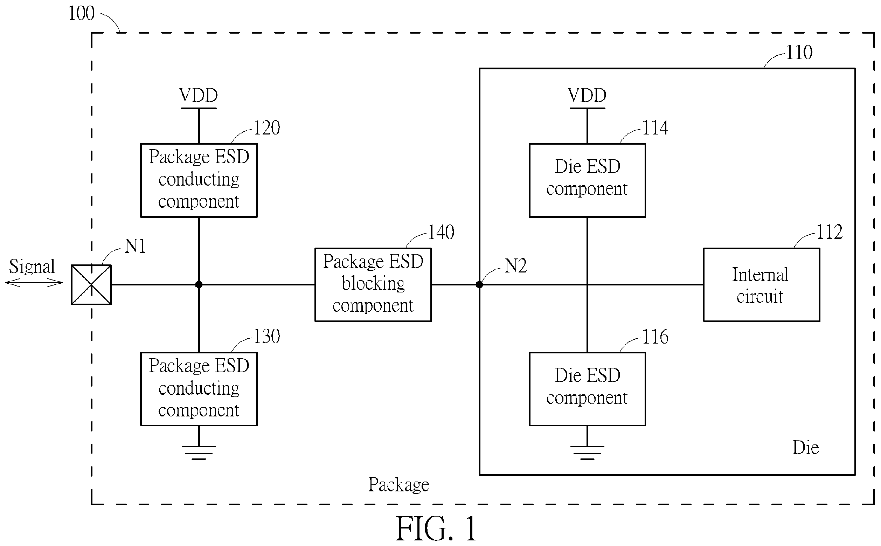

FIG. 1 is a diagram illustrating a package 100 according to one embodiment of the present invention, wherein the package 100 can be any integrated circuit (IC) package such as chip-on-wafer-on-substrate (CoWoS), integrated fan out (InFO) or any other two-dimensional IC package or three-dimensional IC package. As shown in FIG. 1, the package 100 comprises a die 110, a package ESD conducting component 120, a package ESD conducting component 130, a package ESD blocking component 140 and a plurality of pads (a pad N1 serves as an example), wherein the die 110 comprises a plurality of pads (a pad N2 serves as an example), an internal circuit 112, a die ESD component 114 and a die ESD component 116. In this embodiment, the pad N1 may be a pin or one of a ball grid array (BGA), and the pad N1 is used to receive a signal from a device outside the package 100, or the pad N1 is used to transmit a signal from the internal circuit 112 to the device outside the package 100. The package ESD conducting component 120 is coupled between a supply voltage VDD and the pad N1, the package ESD conducting component 130 connected between a ground voltage and the pad N1, and the package ESD blocking component 140 is coupled between the pad N1 and the pad N2. In addition, the die ESD component is coupled between the supply voltage VDD and the pad N2, the die ESD component is coupled between the ground voltage and the pad N2, and the internal circuit 112 is configured to receive and process the signal from the pad N1 via the package ESD blocking component 140 and the pad N2.

In the embodiment shown in FIG. 1, three package ESD components are designed within the package 100 to protect the internal circuit 112 against the ESD damage, however, the number and type of package ESD components are not limitations of the present invention. In another embodiment, one or two of the package ESD conducting component 120, the package ESD conducting component 130 and the package ESD blocking component 140 can be removed from the package 100.

By designing the package ESD components between the pad N1 and the die 110, most of the ESD current can be bypassed by the package ESD conducting component 130 or blocked by the package ESD blocking component 140, so the remaining ESD current flowing into the die 110 will only induce small voltage drop, and package 100 can meet the requirements of the ESD specifications for high-speed RF designs. In addition, because the package ESD components with lower parasitic effects have better quality factor control and ESD robustness, the package 100 with the package ESD components will have better performance.

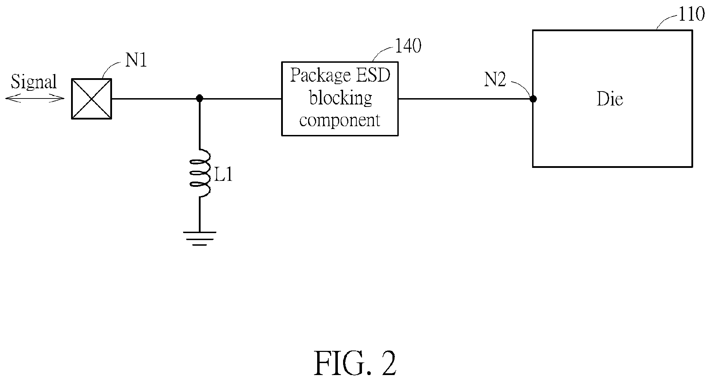

FIG. 2 is a diagram illustrating the package ESD components according to a first embodiment of the present invention. As shown in FIG. 2, the package 100 comprises the package ESD conducting component 130 and the package ESD blocking component 140, wherein the package ESD conducting component 130 is implemented by using an inductor L1, that is one node of the inductor L1 is coupled to the pad N1, and the other node of the inductor L1 is coupled to the ground voltage.

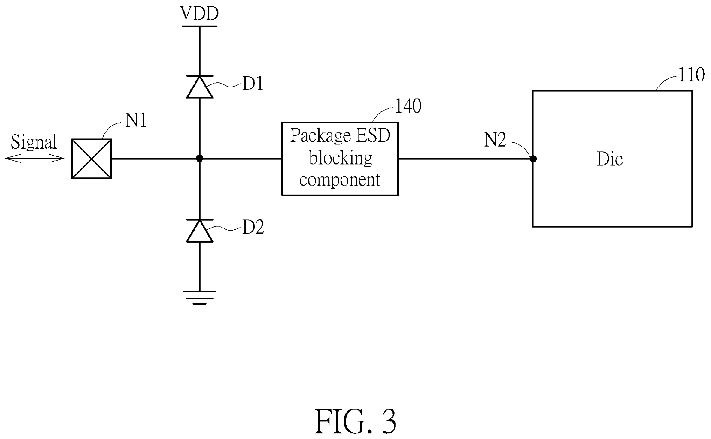

FIG. 3 is a diagram illustrating the package ESD components according to a second embodiment of the present invention. As shown in FIG. 3, the package 100 comprises the package ESD conducting component 120, the package ESD conducting component 130 and the package ESD blocking component 140. The package ESD conducting component 120 is implemented by using a diode D1, wherein an anode of the diode D1 is coupled to the pad N1, and a cathode of the diode D1 is coupled to the supply voltage VDD. The package ESD conducting component 130 is implemented by using a diode D2, wherein an anode of the diode D2 is coupled to the ground voltage, and a cathode of the diode D2 is coupled to the pad N1.

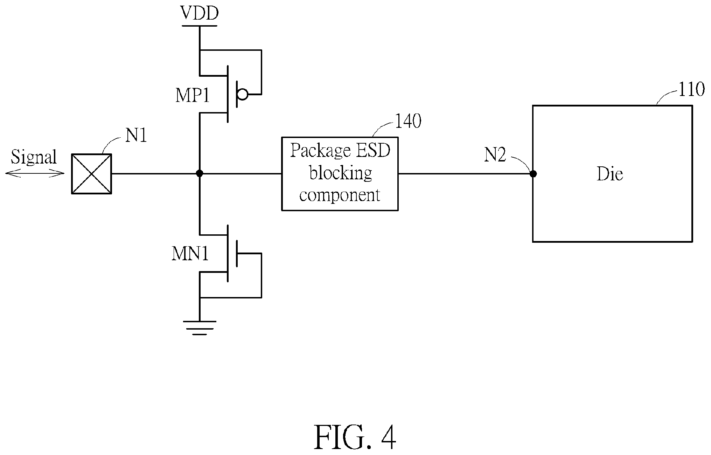

FIG. 4 is a diagram illustrating the package ESD components according to a third embodiment of the present invention. As shown in FIG. 4, the package 100 comprises the package ESD conducting component 120, the package ESD conducting component 130 and the package ESD blocking component 140. The package ESD conducting component 120 is implemented by using a P-type transistor MP1, wherein a source electrode of the P-type transistor MP1 is coupled to the supply voltage VDD, and a drain electrode of the P-type transistor MP1 is coupled to the pad N1. The package ESD conducting component 130 is implemented by using an N-type transistor MN1, wherein a source electrode of the N-type transistor MN1 is coupled to the ground voltage, and a drain electrode of the N-type transistor MN1 is coupled to the pad N1.

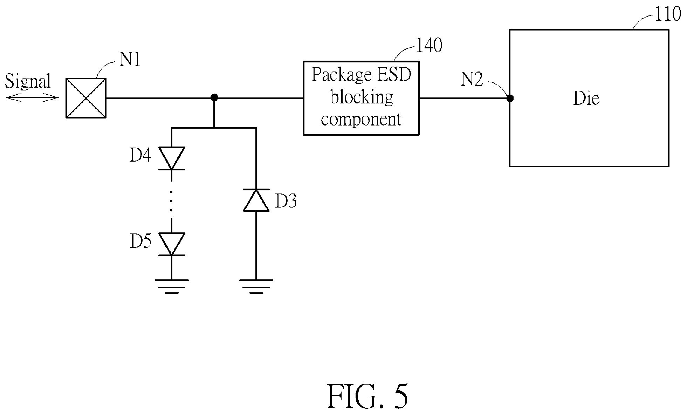

FIG. 5 is a diagram illustrating the package ESD components according to a fourth embodiment of the present invention. As shown in FIG. 5, the package 100 comprises the package ESD conducting component 130 and the package ESD blocking component 140. The package ESD conducting component 130 is implemented by using forward diode(s) D4 and D5 and reverse diode(s) D3. An anode of the diode D3 is coupled to the ground voltage, and a cathode of the diode D3 is coupled to the pad N1. The diodes D4 and D5 are connected in series, wherein an anode of the diode D4 is coupled to the pad N1, and a cathode of the diode D5 is coupled to the ground voltage.

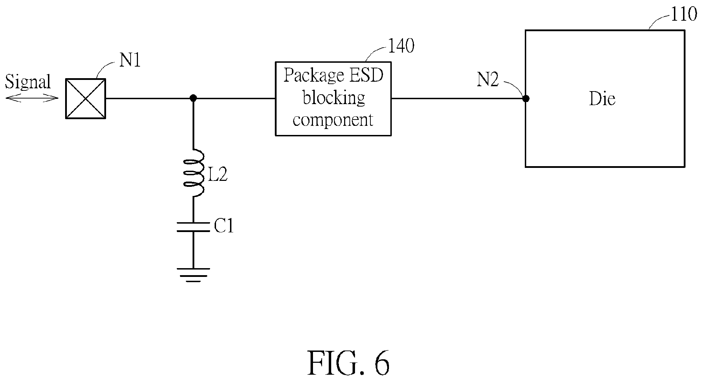

FIG. 6 is a diagram illustrating the package ESD components according to a fifth embodiment of the present invention. As shown in FIG. 6, the package 100 comprises the package ESD conducting component 130 and the package ESD blocking component 140. The package ESD conducting component 130 is implemented by using an inductor L2 and a capacitor C1 connected in series, wherein a first node of the inductor L2 is coupled to the pad N1, a second node of the inductor L2 is coupled to a first node of the capacitor C1, and a second node of the capacitor C1 is coupled to the ground voltage.

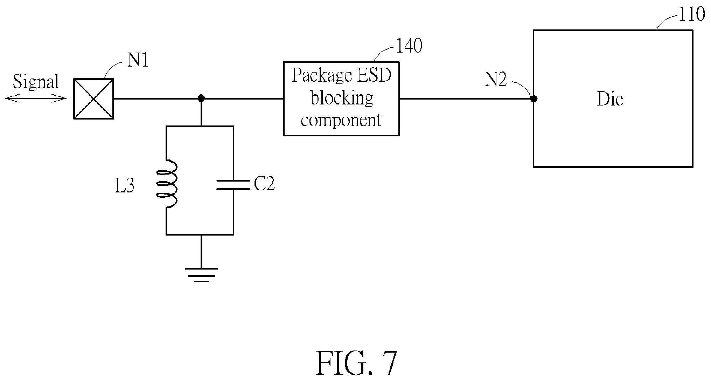

FIG. 7 is a diagram illustrating the package ESD components according to a sixth embodiment of the present invention. As shown in FIG. 7, the package 100 comprises the package ESD conducting component 130 and the package ESD blocking component 140. The package ESD conducting component 130 is implemented by using an inductor L3 and a capacitor C2 connected in parallel, wherein a first node of the inductor L3 is coupled to the pad N1, a second node of the inductor L3 is coupled to the ground voltage, a first node of the capacitor C2 is coupled to the pad N1, a second node of the capacitor C2 is coupled to the ground voltage.

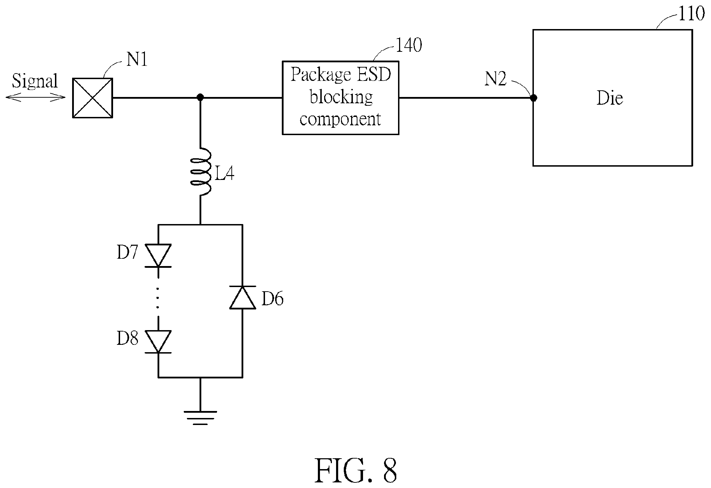

FIG. 8 is a diagram illustrating the package ESD components according to a seventh embodiment of the present invention. As shown in FIG. 8, the package 100 comprises the package ESD conducting component 130 and the package ESD blocking component 140. The package ESD conducting component 130 is implemented by using an inductor L4, forward diode(s) D7 and D8 and reverse diode(s) D6. A first node of the inductor L4 is coupled to the pad N1, an anode of the diode D3 is coupled to the ground voltage, and a cathode of the diode D3 is coupled to a second node of the inductor L4. The diodes D4 and D5 are connected in series, wherein an anode of the diode D4 is coupled to the second node of the inductor L4, and a cathode of the diode D5 is coupled to the ground voltage.

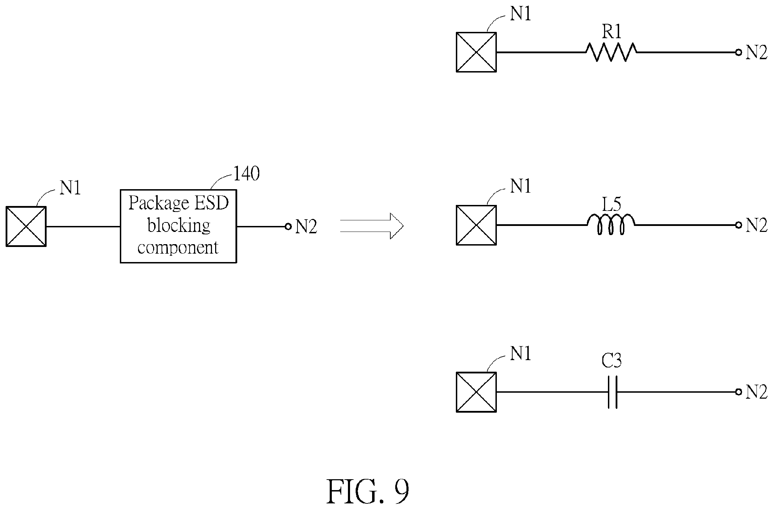

FIG. 9 is a diagram showing some embodiments of the package ESD blocking component 140 coupled between the pad N1 and the pad N2. As shown in FIG. 9, the package ESD blocking component 140 can be implemented by using a resistor R1, an inductor L5 or a capacitor C3, wherein a first node of the resistor R1, the inductor L5 or the capacitor C3 is coupled to the pad N1, and a second node of the resistor R1, the inductor L5 or the capacitor C3 is coupled to the pad N2.

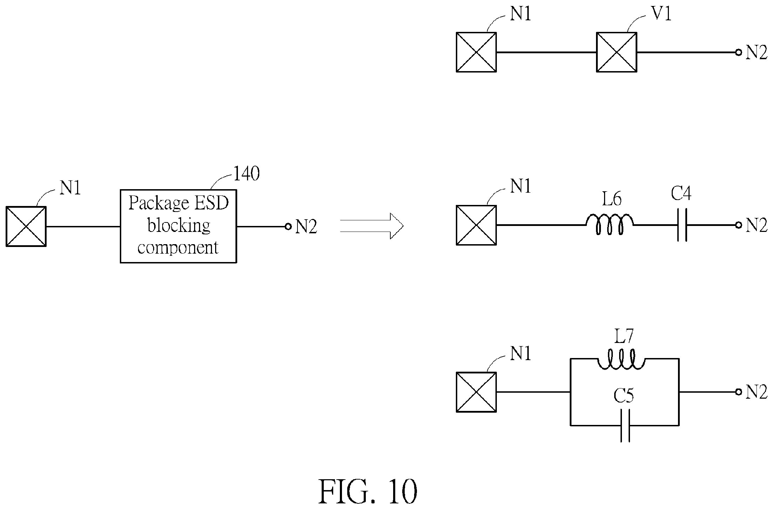

FIG. 10 is a diagram showing some embodiments of the package ESD blocking component 140 coupled between the pad N1 and the pad N2. As shown in FIG. 9, the package ESD blocking component 140 can be implemented by using via hole, wherein the via hole is manufactured by a plurality of metal layers. The package ESD blocking component 140 can be implemented by using an inductor L6 and a capacitor C4 connected in series, wherein a first node of the inductor L6 is coupled to the pad N1, a second node of the inductor L6 is coupled to a firs node of the capacitor C4, and a second node of the capacitor C4 is coupled to the pad N2. The package ESD blocking component 140 can be implemented by using an inductor L7 and a capacitor C5 connected in parallel, wherein a first node of the inductor L7 is coupled to the pad N1, a second node of the inductor L7 is coupled to the pad N2, a first node of the capacitor C5 is coupled to the pad N1, and a second node of the capacitor C5 is coupled to the pad N2.

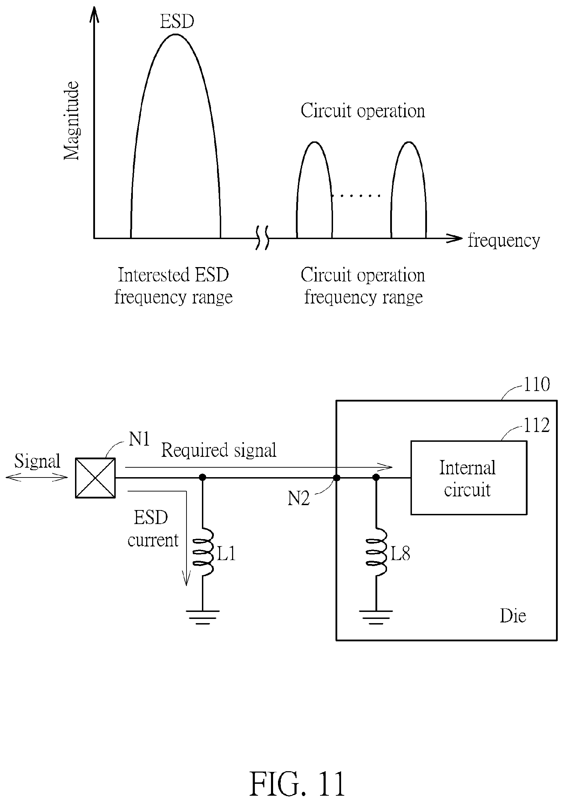

In one embodiment, when the die 110 comprises a circuit for processing a signal, the package ESD conducting component 130 can be implemented by using the inductor L1 shown in FIG. 2 to bypass the ESD current. As shown in FIG. 11, the ESD frequency is within a lower frequency range, a frequency of required signal is within a higher frequency range, the inductor L1 serves as a high-pass filter to bypass the ESD current to the ground, and the high-frequency component can enter the pad N2 of the die 110. In addition, the die ESD component 116 within the die 110 can also be implemented by using an inductor L8, to bypass the remaining ESD current to the ground.

In one embodiment, the die comprises an RF circuit for processing a millimeter wave (mmW) signal, the ESD frequency may be ranging from 100 MHz to 6GHz, and a frequency of the required millimeter wave signal is ranging from 24 GHz to 40 GHz.

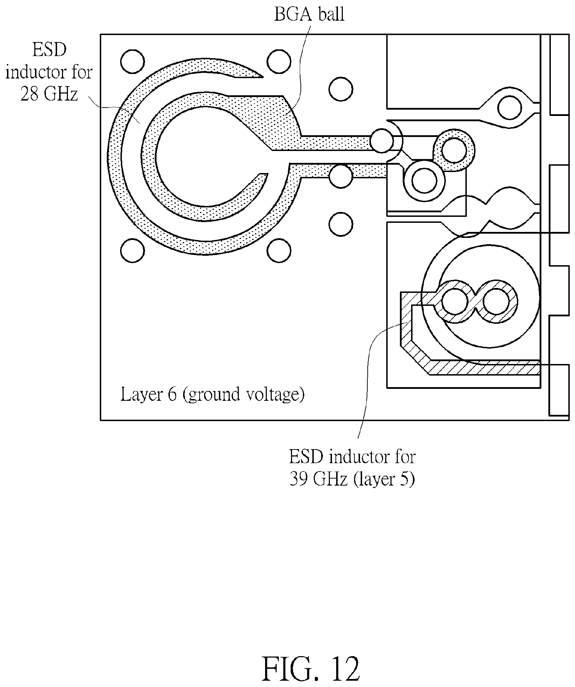

In the embodiment shown in FIG. 11, the inductor L1 can have different designs for different frequencies. Taking FIG. 12 as an example, not a limitation of the present invention, when the pad N1 is used to receive or transmit the millimeter wave signal with 28 GHz, the inductor L1 can be formed by using a sixth metal layer having the ground voltage around a BGA ball; and when the pad N1 is used to receive or transmit the millimeter wave signal with 39 GHz, the inductor L1 can be formed by using a fifth metal layer in keep-out zone.

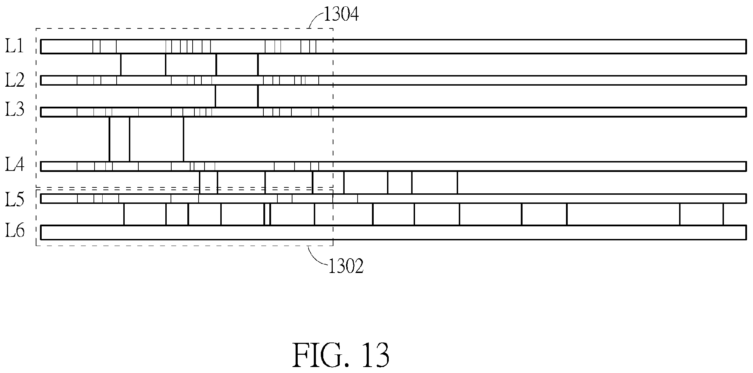

FIG. 13 is a diagram illustrating a vertical cross-sectional view of the circuit connected to the BGA ball. As shown in FIG. 1, the circuits comprise a first component 1302 and a second component 1304, wherein the first component 1302 can be the package ESD conducting component formed by using the fifth metal layer L5 and the sixth metal layer 6, and the second component 1304 can be the package ESD blocking component formed by using a first metal layer to a fourth metal layer L1 - L4.

Briefly summarized, in the embodiments of the present invention, by designing one or more package-level ESD component(s) between the die and the pad(s) of the package, most of the ESD current can be bypassed outside the die, and the remaining ESD current flowing into the die will only induce small voltage drop. In addition, because the package ESD components with lower parasitic effects have better quality factor control and ESD robustness, the package with the package ESD components will have better performance.

Those skilled in the art will readily observe that numerous modifications and alterations of the device and method may be made while retaining the teachings of the invention. Accordingly, the invention is defined by the appended claims.

The present invention may also be defined by the following numbered clauses.
Clause 1. A package, comprising: a first pad, configured to receive a signal from a device external to the package or transmit a signal from an internal circuit to the device external to the package; a die comprising a second pad and the internal circuit, wherein the internal circuit is configured to receive the signal from the first pad via the second pad or transmit the signal to the first pad via the second pad; and at least one package electrostatic discharge (ESD) component, wherein the at least one package ESD component is positioned outside the die.
Clause 2. The package of clause 1, wherein the at least one package ESD component comprises a package ESD conducting component coupled between the first pad and a ground voltage.
Clause 3. The package of clause 2, wherein the package ESD conducting component comprises an inductor, a first node of the inductor is coupled to the first pad, and the second node of the inductor is coupled to the ground voltage.
Clause 4. The package of clause 3, wherein the signal is an analog or digital or RF signal, the package ESD conducting component serves as a high-pass filter to bypass an ESD current, and the die comprises a circuit configured to process the analog or digital or RF signal.
Clause 5. The package of clause 2, wherein the package ESD conducting component comprises at least one forward diode and at least one reverse diode connected in parallel.
Clause 6. The package of clause 2, wherein the package ESD conducting component comprises an inductor and a capacitor connected in series.
Clause 7. The package of clause 2, wherein the package ESD conducting component comprises an inductor and a capacitor connected in parallel.
Clause 8. The package of clause 1, wherein the at least one package ESD component comprises a first package ESD conducting component and a second package ESD conducting component, the first package ESD conducting component is coupled between a supply voltage and the first pad, and the second package ESD conducting component is coupled between a ground voltage and the first pad.
Clause 9. The package of clause 8, wherein each of the first package ESD conducting component and the second package ESD conducting component is a diode.
Clause 10. The package of clause 8, wherein the first package ESD conducting component is a P-type transistor, and the second package ESD conducting component is an N-type transistor.
Clause 11. The package of clause 1, wherein the at least one package ESD component comprises a package ESD blocking component coupled between the first pad and the second pad.
Clause 12. The package of clause 11, wherein the package ESD blocking component comprises a resistor, an inductor or a capacitor coupled between the first pad and the second pad.
Clause 13. The package of clause 11, wherein the package ESD blocking component comprises an inductor and a capacitor, and the inductor and the capacitor are connected in series or parallel.

## Claims

1. A package (100), comprising:
a first pad (N1), configured to receive a signal from a device external to the package (100) or transmit a signal from an internal circuit (112) to the device external to the package (100);
a die (110) comprising a second pad (N2) and the internal circuit (112), wherein the internal circuit (112) is configured to receive the signal from the first pad (N1) via the second pad (N2) or transmit the signal to the first pad (N1) via the second pad (N2); and
at least one package electrostatic discharge, ESD, component (130), wherein the at least one package ESD component (130) is positioned outside the die (110);
wherein the at least one package ESD component (130) comprises an inductor (L4), at least one forward diode (D7, D8) and at least one reverse diode (D6), the at least one forward diode (D7, D8) and the at least one reverse diode (D6) being connected in parallel between a second node of the inductor (L4) and a ground voltage, with an anode of the at least one forward diode (D7) and a cathode of the at least one reverse diode (D6) coupled to the second node of the inductor (L4), and a first node of the inductor (L4) being coupled to the first pad (N1).

2. The package (100) of claim 1, wherein the at least one forward diode comprises a first forward diode (D7) and a second forward diode (D8) connected in series, an anode of the first forward diode (D7) is coupled to the second node of the inductor (L4), and a cathode of the second forward diode (D8) is coupled to the ground voltage.

3. The package (100) of claim 1 or 2, further comprising a package ESD blocking component (140) coupled between the first pad (N1) and the second pad (N2).

4. The package (100) of claim 3, wherein the package ESD blocking component (140) comprises a resistor (R1), an inductor (L5), or a capacitor (C3) coupled between the first pad (N1) and the second pad (N2).

5. The package (100) of claim 3, wherein the package ESD blocking component (140) comprises a via hole formed by a plurality of metal layers.

6. The package (100) of claim 3, wherein the package ESD blocking component (140) comprises an inductor (L6) and a capacitor (C4) connected in series between the first pad (N1) and the second pad (N2).

7. The package (100) of claim 3, wherein the package ESD blocking component (140) comprises an inductor (L7) and a capacitor (C5) connected in parallel between the first pad (N1) and the second pad (N2).

8. The package (100) of any one of claims 1 to 7, wherein the first pad (N1) is a pin or a ball of a ball grid array, BGA.

9. The package (100) of any one of claims 1 to 8, wherein the package (100) is a chip-on-wafer-on-substrate, CoWoS, package, an integrated fan-out, InFO, package, a two-dimensional integrated circuit package, or a three-dimensional integrated circuit package.
